Europäisches Patentamt

European Patent Office

Office européen des brevets

(19)

(11) Numéro de publication : **0 487 386 B1**

# (12) FASCICULE DE BREVET EUROPEEN

(45) Date de publication du fascicule du brevet :
20.12.95 Bulletin 95/51

(51) Int. Cl.⁶ : **H03B 19/14**

(21) Numéro de dépôt : **91403082.0**

(22) Date de dépôt : **15.11.91**

(54) **Dispositif doubleur de fréquence**

(30) Priorité : **23.11.90 FR 9014619**

(43) Date de publication de la demande :
**27.05.92 Bulletin 92/22**

(45) Mention de la délivrance du brevet :
**20.12.95 Bulletin 95/51**

(84) Etats contractants désignés :
**DE ES FR GB IT SE**

(56) Documents cités :
**FR-A- 2 631 758**
**INTERNATIONAL JOURNAL OF ELECTRO-**
**NICS. vol. 65, no. 6, Décembre 1988, LONDON**
**GB pages 1203 - 1208; W. SURAKAMPON-**
**TORN: 'DUAL TRANSLINEAR SINUSOIDAL**
**FREQUENCY DOUBLER AND FULL-WAVE**
**RECTIFIER'**
**\* le document en entier \***
**IEEE JOURNAL OF SOLID-STATE CIRCUITS.**
**vol. SC11, no. 2, Avril 1976, NEW YORK US**
**pages 341 - 343; S. ASHOK: 'INTEGRATABLE**
**SINUSOIDAL FREQUENCY DOUBLER'**

(56) Documents cités :
**IEEE TRANSACTIONS ON INSTRUMENTA-**
**TION AND MEASUREMENT. vol. 37, no. 2, Juin**
**1988, NEW YORK US pages 259 - 262; W.**
**SURAKAMPONTORN: 'SINUSOIDAL FRE-**
**QUENCY DOUBLERS USING OPERATIONAL**
**AMPLIFIERS'**
**PATENT ABSTRACTS OF JAPAN vol. 008, no.**
**095 (E-242)2 Mai 1984 & JP-A-59 013 416 (**
**MATSUSHITA DENKI SANGYO KK ) 24 Janvier**
**1984**
**INTERNATIONAL JOURNAL OF ELECTRO-**
**NICS. vol. 44, no. 5, Mai 1978, LONDON GB**
**pages 461 - 464; R.W.J. BARKER: 'TRANSLI-**
**NEAR FREQUENCY DOUBLER'**

(73) Titulaire : **THOMSON-CSF**
**173, Boulevard Haussmann**
**F-75008 Paris (FR)**

(72) Inventeur : **Besson, Yves**
**THOMSON-CSF,SCPI,Cédex 67**
**F-92045 Paris la Défense (FR)**
Inventeur : **Ginguene, Sylviane**
**THOMSON-CSF,SCPI,Cédex 67**
**F-92045 Paris la Défense (FR)**

(74) Mandataire : **Benoit, Monique et al**
**THOMSON-CSFSCPIB.P. 32950, rue**
**Jean-Pierre Timbaud**
**F-92402 Courbevoie Cédex (FR)**

## Description

Le domaine de l'invention est celui des dispositifs doubleurs de fréquence. Plus précisément, la présente invention concerne un doubleur de fréquence faible bruit, pouvant notamment fonctionner à des fréquences de l'ordre de quelques GHz, voire quelques dizaines de GHz.

Les dispositifs doubleurs de fréquence pouvant fonctionner à de telles fréquences sont notamment utilisés dans les radars et dans les appareils effectuant de la génération et de la synthèse de fréquence pour générer des hautes fréquences stables à partir de sources basses fréquences également stables.

Le signal basse fréquence peut par exemple être obtenu à l'aide d'un quartz, ce qui permet de disposer d'une fréquence de base très stable. Une mise en série de dispositifs doubleurs de fréquence permet d'augmenter rapidement la fréquence du signal et d'obtenir un signal haute fréquence de fréquence stable. Afin de réduire le nombre de multiplications nécessaires pour atteindre la haute fréquence désirée, il est intéressant de disposer d'une source BF stable de fréquence relativement élevée.

La plupart des dispositifs doubleurs de fréquence utilisés sont basés sur l'introduction d'une distorsion du signal sinusoïdal incident à la fréquence F pour enrichir le spectre et créer ainsi des fréquences harmoniques de la fréquence d'entrée: 2F, 3F, 4F, etc... Un filtrage sélectif permet ensuite de recueillir l'harmonique souhaité à condition que celui-ci ait été généré avec un rendement suffisant. Dans le cas de doubleurs de fréquence, c'est l'harmonique de fréquence 2F qui est sélectionné. Parfois le circuit de distorsion lui-même, avec des choix judicieux de caractéristiques réalise un autofiltrage.

Une description d'une telle réalisation est décrite dans un article du "International Journal of Electronics", Vol. 65, n° 6, décembre 1988, pages 1203 à 1208. Cet article est relatif à des boucles translinéaires comprenant deux transistors bipolaires n-p-n et deux transistors bipolaires p-n-p. L'auteur y explique qu'avec certains choix de branchements et de polarisation il est possible d'utiliser ces circuits en redresseurs demi-onde ou en doubleur de fréquence. En ce qui concerne l'utilisation en doubleur de fréquence, l'auteur montre que la valeur du courant de sortie Io exprimée sous forme de développement limité peut être rendue sensiblement égale, à une expression correspondant à une constante additive et un coefficient multiplicateur près au développement limité de cos $2\omega t$, expression dans laquelle $\omega$ est la pulsation du signal d'entrée. Il suffit pour cela de choisir les constantes du circuit boucle pour que dans l'expression du développement limité du courant de sortie Io les coefficients correspondant aux expressions des courants harmoniques soient minimisées.

Selon l'opération effectuée pour distordre le signal sinusoïdal incident (écrêtage, redressement, ébasage,...) et la manière dont elle est effectuée, on peut générer les harmoniques désirés. En général, cette opération est réalisée avec un rendement plus ou moins satisfaisant et l'on obtient une dégradation plus ou moins importante du spectre de bruit de phase et/ou d'amplitude.

On connaît divers types de dispositifs capables de générer des fréquences multiples d'un signal BF.

On peut par exemple utiliser une diode à stockage (diode "snap-off") qui emmagasine toute l'énergie d'une période d'un signal sinusoidal de fréquence F qui lui est appliqué pour la restituer sous la forme d'une impulsion de Dirac, c'est à dire en un temps très bref. Comme la largeur spectrale du signal obtenu est très importante, il est nécessaire de filtrer ce signal pour en extraire l'harmonique de fréquence souhaitée, par exemple 2F.

Le principal inconvénient de ce type de dispositif est que le niveau du bruit introduit est relativement important et ne convient pas pour des applications faible bruit.

Une autre méthode permettant d'augmenter la fréquence d'un signal exploite le fait qu'un signal incident de fréquence F multiplié par lui-même permet d'obtenir un signal d'amplitude égale au carré du signal incident et de fréquence double. La multiplication d'un signal par lui-même permettant d'augmenter sa fréquence, il est possible d'obtenir un signal de quelques dizaines de GHz à partir d'un signal basse fréquence de quelques dizaines de MHz.

On peut par exemple utiliser un mélangeur attaqué par deux signaux identiques de même fréquence, mais l'opération de multiplication n'est pas linéaire et on ne fabrique pas exclusivement l'harmonique de rang 2 et le spectre s'en trouve alors inutilement enrichi.

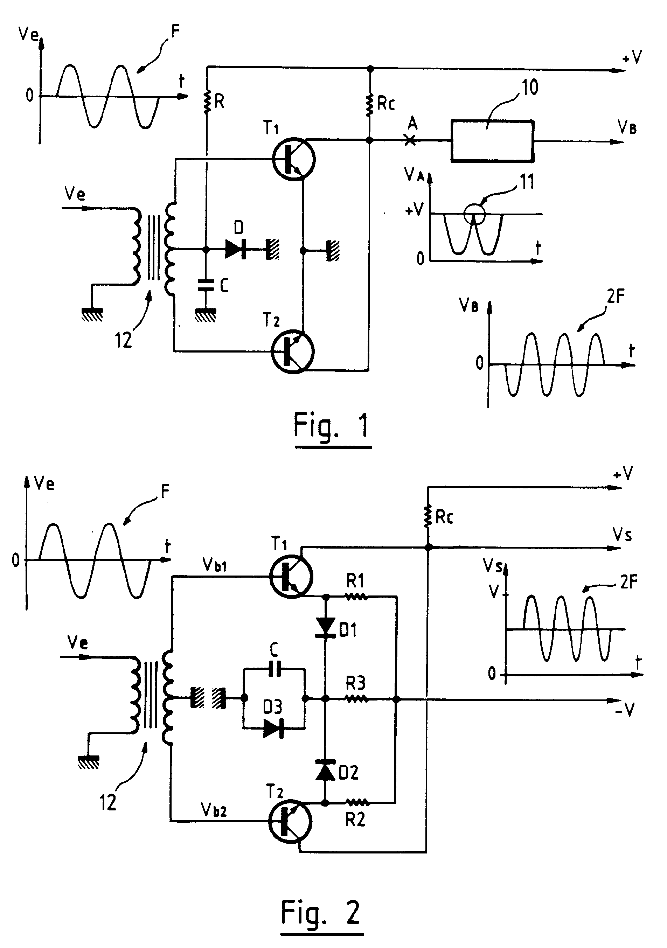

Un autre type de doubleur de fréquence est représenté à la figure 1. Cette figure représente un doubleur de fréquence par redressement double alternance.

Un signal sinusoidal Ve de fréquence F est appliqué à l'entrée du dispositif au primaire d'un transformateur 12 dont les sorties sont différentielles symétriques par rapport au point milieu du secondaire du transformateur 12 relié à l'anode d'une diode D dont la cathode est reliée à la masse. Un condensateur C est branché en parallèle de la diode D et les deux composants coopèrent pour maintenir une tension égale à la tension de seuil de la diode sur le point milieu du secondaire du transformateur 12. La diode D est alimentée en courant par une tension d'alimentation +V à travers une résistance R. Les sorties différentielles symétriques du transformateur 12 sont chacune reliées à la base d'un transistor bipolaire $T_1, T_2$. Les émetteurs des transistors $T_1$ et $T_2$ sont reliés à la masse et leurs collecteurs sont reliés à une résistance de charge $R_c$. Le point commun des deux transis-

tors $T_1$ et $T_2$ (point A) est relié à l'entrée d'un filtre 10. Le signal de sortie Vb du filtre 10 est un signal sinusoïdal de fréquence 2F.

Le fonctionnement du doubleur de fréquence est le suivant: les signaux appliqués sur les bases des transistors $T_1$ et $T_2$ étant en opposition de phase, chaque transistor amplifie une alternance du signal d'entrée pendant que l'autre transistor est bloqué. La diode D et le condensateur C effectuent un déseuillage des transistors pour compenser les $V_{be}$ des transistors. La tension de seuil de la diode est généralement de l'ordre de 0,6 à 0,7 volts. Le fonctionnement du doubleur de fréquence est donc un fonctionnement push-pull (c'est à dire symétrique) classe B. Le signal Va au point A est formé d'arches de sinusoïde redressée juxtaposées, les transistors $T_1$ et $T_2$ générant alternativement une arche de sinusoïde. La jonction d'une arche de sinusoïde à l'autre est abrupte, le signal Va présentant des points de rebroussement 11 porteurs de spectres à fréquences très élevées. Le filtre 10 élimine la fréquence F de base et fournit en sortie le signal Vb de fréquence 2F. Le gain du montage est constant puisque les émetteurs sont reliés à la masse et dépend des transistors $T_1$ et $T_2$ (valeur de la résistance dynamique d'émetteur).

L'utilisation en série de plusieurs modules de ce type permet d'augmenter considérablement la fréquence d'un signal incident, la sortie du premier module fournissant 2F, la sortie du deuxième fournissant 4F, le troisième 8F, etc...

Cependant, comme le redressement double alternance crée des points de rebroussement 11 à spectre très riche (on observe des raies de plusieurs GHz pour une fréquence de signal d'entrée Ve de l'ordre de 150 MHz), il n'est pas possible de totalement contrôler ce spectre et on observe des fuites à l'origine de phénomènes parasites.

Ces phénomènes parasites rendent le dispositif sensible aux vibrations lorsqu'il est monté dans un boîtier faisant par exemple partie d'une chaîne (montage en série) de doubleurs de fréquence. De plus, les fréquences parasites peuvent créer des ondes stationnaires dans le boîtier et des vibrations d'ordre mécanique peuvent moduler ces ondes. La forme du signal de sortie Vb s'en trouve alors fortement affectée.

De plus, un filtre destiné à sélectionner un harmonique occupe une place non négligeable dans les boîtiers constituant une chaîne de doubleurs de fréquence et les problèmes d'encombrement sont nombreux dans les appareils utilisant de tels doubleurs de fréquence.

Il n'est pas non plus possible de modifier, ne serait-ce que légèrement, la fréquence du signal d'entrée, car le filtre est centré sur une fréquence fixe. Ainsi, si l'on veut obtenir une fréquence de sortie d'une chaîne de doubleurs de fréquence différente ou alors modifier la fréquence F du signal incident de base d'une telle chaîne, il est nécessaire de changer tous les filtres présents dans les doubleurs de fréquence d'une telle chaîne.

Un inconvénient supplémentaire résultant de la présence d'un filtre est l'augmentation du prix de revient d'un tel doubleur de fréquence.

La présente invention selon la revendication 1 a notamment pour objectif de pallier ces inconvénients.

Plus précisément, un des objectifs de la présente invention est de fournir un dispositif doubleur de fréquence qui génère peu ou pas d'harmoniques de rang élevé et que les niveaux de ces harmoniques soient faibles, de telle sorte qu'il ne nécessite pas de filtre de sélection de la fréquence 2F, ou nécessite tout du moins un filtre moins sélectif que ceux utilisés dans l'état de la technique, et soit donc de prix de revient plus réduit.

Un autre objectif de la présente invention est de fournir un tel doubleur de fréquence pouvant fonctionner dans une gamme de fréquence très importante, allant de la basse fréquence à quelques GHz, voire quelques dizaines de GHz.

Un objectif complémentaire de la présente invention est de fournir un tel doubleur de fréquence qui soit de structure proche de celle du doubleur de fréquence décrit précédemment en référence à la figure 1, de telle sorte qu'il soit possible de modifier aisément les doubleurs de fréquence de ce type déjà utilisés pour les rendre conformes au dispositif de l'invention.

Ces objectifs, ainsi que d'autres qui apparaîtront par la suite, sont atteints grâce à un doubleur de fréquence, fonctionnant notamment dans le domaine des hyperfréquences, du type comprenant des moyens de déphasage permettant d'obtenir deux signaux déphasés de 180° à partir d'un signal d'entrée de fréquence F et des moyens d'amplification de chacun desdits signaux déphasés de 180°, le signal de sortie de fréquence 2F étant formé de la sommation desdits signaux amplifiés, lesdits moyens d'amplification coopérant avec des moyens de variation de gain desdits moyens d'amplification pour rendre le gain desdits moyens d'amplification sensiblement proportionnel à l'amplitude desdits signaux.

Lesdits moyens de variation de gain sont constitués de diodes dont la résistance dynamique varie avec la tension qui leur est appliquée.

Avantageusement, lesdits moyens d'amplification sont constitués de transistors bipolaires.

Selon un mode de réalisation de l'invention, lesdits signaux déphasés de 180° sont appliqués sur les bases desdits transistors, les collecteurs desdits transistors étant reliés entre eux, et en ce que les émetteurs desdits transistors sont chacun reliés à l'anode d'une desdites diodes, les cathodes desdites diodes étant reliées entre elles.

Avantageusement, lesdits transistors coopèrent avec des moyens permettant de compenser les tensions de seuil desdits transistors.

Préférentiellement, lesdits moyens permettant de compenser les tensions de seuil desdits transistors coopèrent avec une diode.

Selon un mode de réalisation de la présente invention, lesdits moyens de déphasage sont constitués par un transformateur au primaire duquel est injecté ledit signal d'entrée de fréquence F, le secondaire dudit transformateur comportant deux sorties différentielles symétriques.

Selon un autre mode de réalisation de l'invention, lesdits moyens de déphasage sont constitués par un module déphaseur de 180° dudit signal d'entrée de fréquence F, l'entrée et la sortie dudit module déphaseur étant respectivement reliées aux bases desdits transistors.

Préférentiellement, lesdits transistors bipolaires et lesdites diodes sont des composants large bande.

Avantageusement, le doubleur de fréquence selon la présente invention est utilisé dans une chaîne de multiplication de fréquence.

D'autres caractéristiques et avantages de la présente invention apparaîtront à la lecture de la description suivante d'un mode de réalisation préférentiel, donné à titre indicatif et non limitatif, et des figures annexées, dans lesquelles:

- la figure 1 représente un doubleur de fréquence par redressement double alternance de type connu;
- la figure 2 représente un mode de réalisation préférentiel d'un doubleur de fréquence selon la présente invention;
- la figure 3 représente les signaux appliqués sur les bases des transistors $T_1$ et $T_2$ et le signal de sortie d'un doubleur de fréquence selon l'invention;
- la figure 4 représente, en corrélation avec la figure 3, les signaux de sortie des transistors $T_1$ et $T_2$.

Comme déjà décrit en référence à la figure 1, le redressement double alternance d'un signal sinusoidal d'entrée de fréquence F permet de générer des harmoniques et un signal de fréquence 2F est récupéré par filtrage.

Le principal inconvénient des dispositifs de ce type est que les harmoniques de spectre élevé ne peuvent être éliminés efficacement par filtrage et sont à l'origine de phénomènes parasites.

La présente invention se propose de générer directement un signal de sortie ayant la forme d'une sinusoide de fréquence double de la fréquence du signal incident, sans nécessiter de filtre de sortie.

C'est pourquoi la présente invention vise à réaliser une opération linéaire d'élévation au carré du signal incident.

Mathématiquement, cette opération consiste à multiplier un signal Ve = k.V.sin wt, avec w = 2.$\pi$.F et F étant la fréquence du signal Ve, par lui-même. Le signal de sortie vaut donc:

$$Vs = k'.V^2.\sin^2 wt = k'.V^2 (1 - \cos 2wt)/2$$

Le signal de sortie comprend donc deux composantes: une composante continue de valeur $k'V^2/2$ et une composante à la fréquence 2F de valeur $(k''V^2.\cos 2wt)/2$.

L'auto-produit d'un signal doit donc être aussi linéaire que possible pour ne pas générer de raies d'ordre supérieur à 2 de niveaux significatifs, contrairement à ce qui se passe dans un mélangeur en anneau.

La figure 2 représente un mode de réalisation préférentiel d'un doubleur de fréquence selon la présente invention.

Le signal incident Ve de fréquence F est appliqué au primaire d'un transformateur 12 présentant deux sorties différentielles symétriques. Le point milieu du secondaire du transformateur 12 est relié à la masse. L'alimentation du montage est assurée par une tension positive +V et par une tension négative -V. Ces deux tensions peuvent être différentes en valeur absolue. Les sorties différentielles du transformateur 12 sont chacune reliées à la base de moyens d'amplification constitués par des transistors bipolaires NPN $T_1$ et $T_2$. Les collecteurs des transistors $T_1$ et $T_2$ sont reliés à une même résistance de charge Rc. Les transistors sont polarisés par un courant de repos convenablement choisi pour que l'étage d'amplification soit linéaire. Deux résistances R1 et R2 fixent un courant moyen dans les transistors $T_1$ et $T_2$.

Un des objectifs de l'invention étant de supprimer les points de rebroussement générant des fréquences indésirables, le doubleur de fréquence comporte des moyens de variation de gain coopérant avec les transistors $T_1$ et $T_2$ de telle sorte que les signaux appliqués $V_{b1}$ et $V_{b2}$ aux bases des deux transistors soient amplifiés en fonction de leur amplitude. Ainsi, le gain est proportionnel à l'amplitude du signal, et l'on a Vs/Ve = k'Ve puisque Vs/Ve = G = k'Ve.

Selon un mode de réalisation préférentiel de l'invention, les moyens de variation de gain sont constitués de deux diodes PIN D1 et D2 dont on exploite la caractéristique de résistance dynamique. La résistance dynamique d'une diode décroit en effet lorsque la tension qui lui est appliquée augmente.

Sur la figure 2, les anodes des diodes D1 et D2 sont reliées aux émetteurs des transistors $T_1$ et $T_2$ et leurs cathodes sont reliées. Les diodes D1 et D2 sont convenablement polarisées et déséuillées par la diode D3 polarisée par R3. Les résistances R1 et R2 fixent un courant moyen dans les transistors $T_1$ et $T_2$.

Les diodes D1 et D2 conduisent d'autant plus que la tension qui leur est appliquée est importante. La chute de leur résistance dynamique augmente le gain de l'étage d'amplification. Ainsi, le gain de chacun des transistors est rendu variable et proportionnel au niveau du signal incident Ve par l'effet des diodes D1 et D2 de résistance dynamique variable avec le niveau appliqué. Au repos, c'est à dire sans signal d'entrée appliqué, il n'y a pas de tension aux bornes de R1 et R2, seul le niveau du signal appliqué modifiant la résistance dynamique des diodes et donc le gain de l'étage. En fonctionnement, les cathodes sont dynamiquement à la masse du fait de la présence du condensateur C.

Au premier ordre, c'est à dire sans harmoniques, le signal de sortie prélevé au point commun des collecteurs de $T_1$ et $T_2$ est proportionnel au carré du signal incident de fréquence F et le signal de sortie a donc directement une fréquence 2F. La mise en série d'un condensateur (non représenté) dans la ligne de sortie permet d'éliminer la tension continue obtenue en sortie.

Bien entendu, d'autres modes de réalisation sont envisageables. On peut citer à titre d'exemple le fait de remplacer le transformateur 12 par un circuit déphaseur de 180° destiné à obtenir un signal de phase opposée au signal incident. L'entrée et la sortie d'un tel circuit déphaseur sont alors respectivement reliées aux bases des transistors $T_1$ et $T_2$. Un té hybride, aussi appelé té magique, peut également remplir cette fonction lorsque la fréquence du signal d'entrée est propageable dans des guides d'ondes hyperfréquence. Il en va de même d'un anneau hybride.

Les transistors $T_1$ et $T_2$ peuvent également être par exemple des transistors PNP. Il est dans ce cas nécessaire de modifier notamment les tensions d'alimentation du circuit et les polarisations des transistors.

La prépolarisation en tension par C et D3 des diodes D1 et D2 peut être avantageusement remplacée par une polarisation en courant en supprimant la diode D3. Une telle polarisation en courant permet d'obtenir un rendement du doubleur de fréquence supérieur à celui obtenu par une polarisation en tension.

Les résistances R1 et R2 ont, selon un mode de réalisation de l'invention une valeur de l'ordre de quelques k$\Omega$ et la valeur du condensateur C dépend de la fréquence F du signal d'entrée Ve. Plus la fréquence F est importante, plus la capacité du condensateur est faible, ce composant limitant la bande de fréquence d'utilisation.

Le fonctionnement du doubleur de fréquence selon l'invention est un fonctionnement en classe B où le passage de l'état bloqué d'un transistor à l'état conducteur est effectué progressivement.

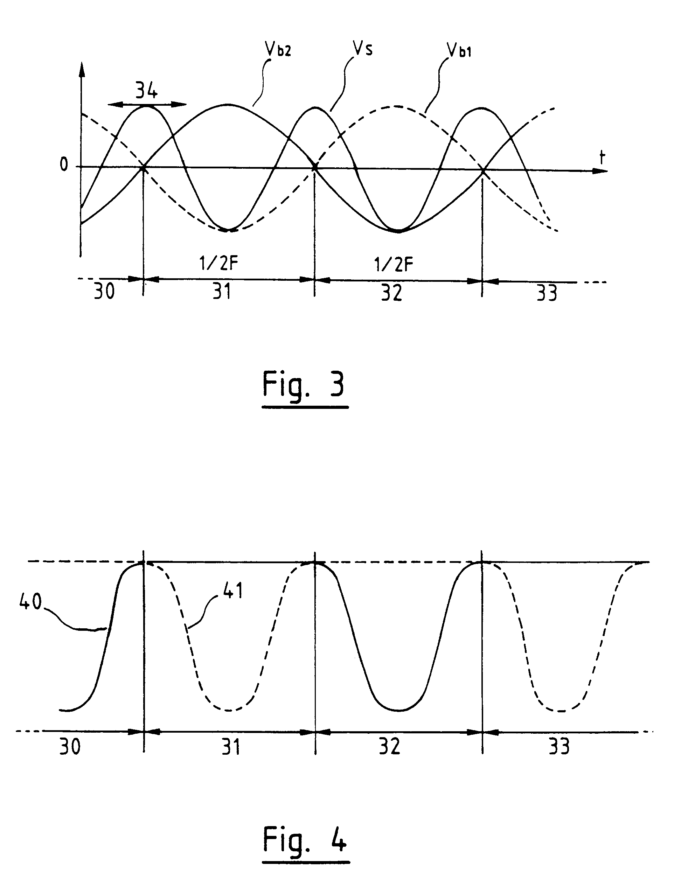

La figure 3 représente les signaux $V_{b1}$ et $V_{b2}$ appliqués sur les bases des transistors $T_1$ et $T_2$ et le signal de sortie Vs d'un doubleur de fréquence selon l'invention. Les signaux $V_{b1}$ et $V_{b2}$ sont issus du transformateur 12 de la figure 2 et sont en opposition de phase.

Le signal de sortie Vs représenté correspond à un signal dont la composante continue a été supprimée, par exemple à l'aide d'un condensateur placé en série à la sortie du doubleur de fréquence.

Selon l'invention, le passage d'une période à l'autre du signal de sortie est effectué "en douceur" contrairement au passage abrupt générateur d'harmoniques de rangs élevés dans les doubleurs de fréquence connus (points de rebroussement 11, fig.1). Ce passage en douceur permet de ne pas générer d'harmoniques gênants. Il est effectué par diminution progressive du gain du transistor conducteur au fur et à mesure que la tension appliquée à la base de ce transistor diminue.

Sur la figure 3, le signal de sortie Vs est partagé en quatre périodes de temps successives.

Pendant la période 30, la tension $V_{b2}$ appliquée à la base du transistor $T_2$ est négative alors que la tension $V_{b1}$ est positive et diminue. Le transistor conducteur est alors le transistor $T_1$ alors que le transistor $T_2$ est bloqué. Comme $V_{b1}$ s'approche du potentiel 0 volts, le gain du transistor $T_1$ diminue, la résistance dynamique de la diode D1 augmentant. Lorsque $V_{b1}$ atteint le potentiel 0 volts, le transistor $T_1$ se bloque et le transistor $T_2$ commence à conduire, la tension $V_{b2}$ étant positive et augmentant.

Pendant la période 31, le transistor $T_1$ est bloqué et le transistor $T_2$ amplifie progressivement le signal $V_{b2}$ appliqué sur sa base, l'amplification étant d'autant plus importante que le signal $V_{b2}$ augmente. Lorsque $V_{b2}$ diminue et s'approche du potentiel 0 volts, le gain du transistor $T_2$ diminue de façon linéaire avec $V_{b2}$, du fait d'une variation de la résistance dynamique de la diode D2. Lors du passage de $V_{b2}$ au potentiel 0, $T_2$ se bloque et $T_1$ redevient conducteur (période 32). Le cycle se poursuit par la période 33 présentant $T_1$ bloqué et $T_2$ conducteur et ainsi de suite jusqu'à ce que la tension d'entrée Ve disparaisse.

On constate donc que chacun des transistors $T_1$ et $T_2$ conduit pendant une demie période du signal d'entrée Ve, le début et la fin d'une demie période correspondant au moment où le signal d'entrée Ve passe par 0. A ce moment là, les deux transistors $T_1$ et $T_2$ ont un gain nul et la commutation est effectuée à tangente horizontale 34. Ce point correspond à l'ancien point de rebroussement 11 (fig.1).

La figure 4 représente, en corrélation avec la figure 3, les signaux de sortie des transistors $T_1$ et $T_2$.

Le signal 40 est celui obtenu sur le collecteur du transistor $T_1$ et le signal 41 celui obtenu sur le collecteur du transistor $T_2$. Lorsqu'un des deux transistors a fini de conduire, il est à l'état bloqué, pendant que l'autre transistor conduit. Comme les deux collecteurs des transistors $T_1$ et $T_2$ sont reliés, le signal de sortie est affecté d'une composante continue qu'il est possible d'éliminer par simple filtrage, par exemple à l'aide d'un condensateur en série avec la sortie.

Les deux voies d'amplification sont totalement indépendantes, chaque transistor fonctionnant pendant une alternance sans que l'état de l'autre transistor n'ait une influence quelconque sur son fonctionnement.

Les transistors $T_1$ et $T_2$ sont avantageusement des transistors appairés, c'est à dire qu'ils présentent les mêmes caractéristiques, pour que la fin de conduction d'un des transistors corresponde au début de conduction de l'autre des transistors et que leur amplification soit égale. Il en va de même des diodes à résistance dynamique variable en fonction de la tension (diodes PIN) servant à mise en conduction et au blocage progressifs des transistors.

Les caractéristiques des transistors et diodes utilisées sont fonction de la fréquence de fonctionnement envisagée. Plus la fréquence F du signal d'entrée sera importante, plus les transistors $T_1$ et $T_2$ et les diodes D1 et D2 devront être rapides.

Un des avantages du doubleur de fréquence de l'invention est que le rapport de la puissance du signal de sortie Vs sur la puissance du signal d'entrée Ve est approximativement de 1, c'est à dire que le doubleur présente un excellent rendement. Cela permet de cascader plusieurs étages ayant les mêmes caractéristiques, sauf bien entendu à adapter les caractéristiques des transistors et des diodes suivant la fréquence de fonctionnement de chaque étage.

La mise en conduction progressive des transistors permet de s'affranchir d'un filtre de sélection d'un harmonique, le signal de sortie présentant, sans filtrage, des harmoniques à des niveaux inférieurs à 25 dB sous la raie de fréquence 2F. Le signal de sortie a une allure très proche de celle d'un signal sinusoidal

Bien entendu, le signal d'entrée Ve peut également être un signal non sinusoidal, par exemple triangulaire, carré, etc...

Le doubleur de fréquence selon l'invention trouve application dans de nombreux domaines. On peut par exemple l'utiliser dans les standards de fréquence, dans les synthétiseurs de mesure (générateurs de fréquences fixes), dans les analyseurs de réseaux, les fréquencemètres, les radars, en émission et réception de télécommunications, les analyseurs de spectre et en général chaque fois que l'on veut doubler la fréquence d'une onde dans les meilleures conditions de rendement et de qualité spectrale en bruit et en raies.

De plus, dans le cas d'applications ne nécessitant pas de filtre, le doubleur de fréquence de l'invention est avantageusement disposé à être utilisé chaque fois que se posent des problèmes d'encombrement et peut être facilement implanté dans un circuit intégré en technologie MMIC (circuit intégré microonde monolithique).

Cette absence de filtre permet notamment d'utiliser le doubleur de fréquence selon l'invention pour des fréquences différentes de celles pour lesquelles il a été calculé, tout en restant dans une gamme de fréquence d'entrée permettant d'obtenir un signal de sortie de fréquence double présentant de bonnes caractéristiques. Cette caractéristique est intéressante lorsque l'on veut obtenir une certaine variation de la fréquence de sortie sans pour autant avoir à modifier toute une chaîne de doubleurs de fréquence.

Par ailleurs, sa structure proche de celle de l'état de la technique (fig.1) permet de modifier aisément les doubleurs de fréquence de ce type déjà existants pour les rendre conformes à la présente invention. Il est bien entendu possible d'intégrer la présente invention dans toute chaîne de doubleur de fréquence déjà existante, en remplacement ou en complément d'autres doubleurs.

## Revendications

1. Doubleur de fréquence, notamment dans le domaine des hyperfréquences recevant un signal d'entrée ($V_e$) de fréquence F et restituant un signal de sortie ($V_s$) de fréquence 2F double du signal d'entrée, du type comportant des moyens de déphasage permettant d'obtenir à partir du signal d'entrée ($V_e$) deux signaux de fréquence F, un premier ($V_{b1}$) et un second ($V_{b2}$), les deux signaux étant déphasés l'un par rapport à l'autre de 180°, le doubleur comportant deux amplificateurs, un premier ($T_1$) et un second ($T_2$) caractérisé en ce que les deux amplificateurs ($T_1$, $T_2$) sont raccordés à une même sortie fournissant le signal de sortie ($V_s$), chacun des amplificateurs ayant un gain nul pendant une demi-alternance du signal périodique d'entrée ($V_e$) et étant pourvu de moyens de variation de gain rendant le gain proportionnel au signal d'entrée pendant l'autre demi-alternance du signal périodique d'entrée, ces moyens de variation étant constitués de diodes ($D_1$, $D_2$) dont la résistance dynamique varie avec la tension qui leur est appliquée, et en ce que le premier amplificateur ($T_1$) reçoit le premier signal ($V_{b1}$), le second amplificateurt ($T_2$) recevant le second signal ($V_{b2}$).

2. Doubleur de fréquence selon la revendication 1, caractérisé en ce que lesdits moyens d'amplification sont constitués de transistors bipolaires ($T_1$, $T_2$).

3. Doubleur de fréquence selon la revendication 2, caractérisé en ce que lesdits signaux ($V_{b1}$, $V_{b2}$) déphasés de 180° sont appliqués sur les bases desdits transistors, les collecteurs desdits transistors étant reliés entre eux, et en ce que les émetteurs desdits transistors ($T_1$, $T_2$) sont chacun reliés à l'anode d'une desdites diodes (D1, D2), les cathodes desdites diodes (D1, D2) étant reliées entre elles.

4. Doubleur de fréquence selon l'une des revendications 2 ou 3, caractérisé en ce que lesdits transistors (T₁, T₂) coopèrent avec des moyens (C) permettant de compenser les tensions de seuil desdits transistors (T₁, T₂).

5. Doubleur de fréquence selon la revendication 4, caractérisé en ce que lesdits moyens (C) permettant de compenser les tensions de seuil desdits transistors (T₁, T₂) coopèrent avec une diode (D3).

6. Doubleur de fréquence selon la revendication 1, caractérisé en ce que lesdits moyens de déphasage sont constitués par un transformateur (12) au primaire duquel est injecté ledit signal d'entrée (Ve) de fréquence F, le secondaire dudit transformateur comportant deux sorties différentielles symétriques.

7. Doubleur de fréquence selon l'une quelconque des revendications 1 ou 2 à 6, caractérisé en ce que lesdits moyens de déphasage sont constitués par un module déphaseur de 180° dudit signal d'entrée (Ve) de fréquence F, l'entrée et la sortie dudit module déphaseur étant respectivement reliées aux bases desdits transistors (T₁, T₂).

8. Doubleur de fréquence selon l'une quelconque des revendications 2 à 6, caractérisé en ce que lesdits transistors (T₁, T₂) et lesdites diodes (D1, D2) sont des composants large bande.

9. Chaîne de multiplication de fréquence, caractérisée en ce qu'elle comporte au moins un doubleur de fréquence selon l'une quelconque des revendications 1 à 8.

**Claims**

1. Frequency doubler, particularly in the UHF field, receiving an input signal (Vₑ) of frequency F and giving back an output signal (Vₛ) of frequency 2F, twice the input signal, of the type including phase-shifting means making it possible, from the input signal (Vₑ), to obtain two signals of frequency F, a first (V_{b1}) and a second (V_{b2}), the two signals being phase-shifted with respect to one another by 180°, the doubler including two amplifiers, a first (T₁) and a second (T₂), characterized in that the two amplifiers (T₁, T₂) are connected to the same output supplying the output signal (Vₛ), each of the amplifiers having zero gain during a half-wave of the periodic input signal (Vₑ) and being provided with gain-variation means making the gain proportional to the input signal during the other half-wave of the periodic input signal, these variation means consisting of diodes (D₁, D₂), the dynamic resistance of which varies with the voltage which is applied to them, and in that the first amplifier (T₁) receives the first signal (V_{b1}), the second amplifier (T₂) receiving the second signal (V_{b2}).

2. Frequency doubler according to Claim 1, characterized in that the said amplification means consist of bipolar transistors (T₁, T₂).

3. Frequency doubler according to Claim 2, characterized in that the said signals (V_{b1}, V_{b2}) phase-shifted by 180° are applied to the bases of the said transistors, the collectors of the said transistors being linked together, and in that the emitters of the said transistors (T₁, T₂) are each linked to the anode of one of the said diodes (D₁, D₂), the cathodes of the said diodes (D₁, D₂) being linked together.

4. Frequency doubler according to one of Claims 2 and 3, characterized in that the said transistors (T₁, T₂) interact with means (C) making it possible to compensate for the threshold voltages of the said transistors (T₁, T₂).

5. Frequency doubler according to Claim 4, characterized in that the said means (C) making it possible to compensate for the threshold voltages of the said transistors (T₁, T₂) interact with a diode (D₃).

6. Frequency doubler according to Claim 1, characterized in that the said phase-shifting means consist of a transformer (12) at the primary of which the said input signal (Vₑ) of frequency F is injected, the secondary of the said transformer including two symmetric differential outputs.

7. Frequency doubler according to any one of Claims 1 or 2 to 6, characterized in that the said phase-shifting means consist of a module phase-shifting the said input signal (Vₑ) of frequency F by 180°, the input and the output of the said phase-shifting module being linked respectively to the bases of the said transistors (T₁, T₂).

8. Frequency doubler according to any one of Claims 2 to 6, characterized in that the said transistors (T₁, T₂) and the said diodes (D₁, D₂) are wideband components.

9. Frequency multiplication chain, characterized in that it includes at least one frequency doubler according to any one of Claims 1 to 8.

**Patentansprüche**

1. Frequenzverdoppler, insbesondere im Höchstfrequenzbereich, der ein Eingangssignal ($V_e$) der Frequenz F empfängt und ein Ausgangssignal ($V_s$) der doppelten Frequenz 2F des Eingangssignals wiederherstellt, des Typs mit Phasenverschiebungsmitteln, die ermöglichen, ausgehend vom Eingangssignal ($V_e$) zwei Signale der Frequenz F, einem ersten ($V_{b1}$) und einem zweiten ($V_{b2}$), zu erhalten, wobei die zwei Signale relativ zueinander um 180° phasenverschoben sind, wobei der Verdoppler zwei Verstärker enthält, einen ersten ($T_1$) und einen zweiten ($T_2$), dadurch gekennzeichnet, daß die zwei Verstärker ($T_1$, $T_2$) mit demselben Ausgang verbunden sind, der das Ausgangssignal ($V_s$) liefert, wobei jeder der Verstärker während einer Halbwelle des periodischen Eingangssignals ($V_e$) eine Nullverstärkung besitzt und mit Mitteln für die Verstärkungsveränderung versehen ist, die die Verstärkung während der anderen Halbwelle des periodischen Eingangssignals proportional zum Eingangssignal machen, wobei diese Veränderungsmittel aus Dioden ($D_1$, $D_2$) gebildet sind, deren dynamischer Widerstand sich mit der Spannung verändert, die an sie angelegt wird, und daß der erste Verstärker ($T_1$) das erste Signal ($V_{b1}$) empfängt, während der zweite Verstärker ($T_2$) das zweite Signal ($V_{b2}$) empfängt.

2. Frequenzverdoppler, nach Anspruch 1, dadurch gekennzeichnet, daß die Verstärkungsmittel aus Bipolartransistoren ($T_1$, $T_2$) gebildet sind.

3. Frequenzverdoppler nach Anspruch 2, dadurch gekennzeichnet, daß die um 180° phasenverschobenen Signale ($V_{b1}$, $V_{b2}$) in die Basen der Transistoren eingegeben werden, wobei die Kollektoren der Transistoren miteinander verbunden sind, und daß die Emitter der Transistoren ($T_1$, $T_2$) jeweils mit der Anode einer der Dioden (D1, D2) verbunden sind, während die Katoden der Dioden (D1, D2) miteinander verbunden sind.

4. Frequenzverdoppler nach einem der Ansprüche 2 oder 3, dadurch gekennzeichnet, daß die Transistoren ($T_1$, $T_2$) mit Mitteln (C) zusammenwirken, die die Kompensation der Schwellenspannungen der Transistoren ($T_1$, $T_2$) ermöglichen.

5. Frequenzverdoppler nach Anspruch 4, dadurch gekennzeichnet, daß die Mittel (C), die die Kompensation der Schwellenspannungen der Transistoren ($T_1$, $T_2$) ermöglichen, mit einer Diode (D3) zusammenwirken.

6. Frequenzverdoppler nach Anspruch 1, dadurch gekennzeichnet, daß die Phasenverschiebungsmittel durch einen Transformator (12) gebildet sind, in dessen Primärwicklung das Eingangssignal (Ve) der Frequenz F eingegeben wird, während die Sekundärwicklung des Transformators zwei symmetrische, differentielle Ausgänge enthält.

7. Frequenzverdoppler nach irgendeinem der Ansprüche 1 oder 2 bis 6, dadurch gekennzeichnet, daß die Phasenverschiebungsmittel durch einen 180°-Phasenverschiebungsmodul für das Eingangssignal (Ve) der Frequenz F gebildet sind, wobei der Eingang und der Ausgang des Phasenverschiebungsmoduls mit der Basis des einen bzw. des anderen der Transistoren ($T_1$, $T_2$) verbunden sind.

8. Frequenzverdoppler nach irgendeinem der Ansprüche 2 bis 6, dadurch gekennzeichnet, daß die Transistoren ($T_1$, $T_2$) und die Dioden (D1, D2) Breitbandkomponenten sind.

9. Frequenzvervielfachungskette, dadurch gekennzeichnet, daß sie wenigstens einen Frequenzverdoppler nach irgendeinem der Ansprüche 1 bis 8 enthält.

Fig. 1

Fig. 2

Fig. 3

Fig. 4